Europäisches Patentamt

European Patent Office

Office européen des brevets

(11) Veröffentlichungsnummer : **0 104 577**
**B1**

(12) # EUROPÄISCHE PATENTSCHRIFT

(45) Veröffentlichungstag der Patentschrift :
01.10.86

(21) Anmeldenummer : 83109268.9

(22) Anmeldetag : 19.09.83

(51) Int. Cl.⁴ : **G 01 R 31/28**

(54) **Verfahren zur kontaktlosen Prüfung eines Objekts, insbesondere von Mikroverdrahtungen, mit einer Korpuskular-strahl-Sonde.**

(30) Priorität : 24.09.82 DE 3235461

(43) Veröffentlichungstag der Anmeldung :
04.04.84 Patentblatt 84/14

(45) Bekanntmachung des Hinweises auf die Patenter-teilung : 01.10.86 Patentblatt 86/40

(84) Benannte Vertragsstaaten :
DE FR GB NL

(56) Entgegenhaltungen :
EP-A- 0 066 070
JOURNAL OF VACUUM SCIENCE & TECHNOLOGY,
Vol. 19, No. 4, November, Dezember 1981 H.C. PFEIF-FER et al. "Contactless electrical testing of large area specimens using electron beams" Seiten 1014-1018

(73) Patentinhaber : Siemens Aktiengesellschaft Berlin und München
Wittelsbacherplatz 2
D-8000 München 2 (DE)

(72) Erfinder : Lischke, Burkhard, Prof. Dr.
In der Huluss 13
D-8000 München 82 (DE)

## Beschreibung

Die Erfindung betrifft ein Verfahren zur kontaktlosen Prüfung eines Objekts, insbesondere von Mikroverdrahtungen, mit einer Korpuskularstrahlsonde nach dem Oberbegriff des Anspruchs 1.

Immer feiner werdende Strukturen in Leiterplatten zwingen dazu, alternative Prüfverfahren für die elektrische Prüfung von Mikroverdrahtungen zu entwickeln. Die elektrische Durchgangsprüfung von Mikroverdrahtungen mit mechanischen Nadeladaptern hat bei einem Rastermaß einer Leiterplatte von etwa 200 μm die Grenze der Anwendungsmöglichkeit von mechanischen Nadeladaptern erreicht.

Alternative Prüfverfahren mit Hilfe von Elektronensonden sind aus dem Stand der Technik bekannt. Beispielsweise ist ein solches Prüfverfahren zur Prüfung von Mikroverdrahtungen mit einer Elektronensonde bekannt, bei dem die Widerstandsmessung einer Leitbahn so erfolgt, daß mit einem ersten Elektronenstrahl eine Ladung und damit ein Potential an einem Ende der Leitbahn eingeprägt wird. Besteht eine leitende Verbindung zum anderen Ende dieser Leitbahn, so nimmt dieses andere Ende der Leitbahn das gleiche Potential an, was mit einem zweiten Elektronenstrahl überprüft werden kann. Dieser zweite Elektronenstrahl wird nämlich auf das andere Ende der Leitbahn gerichtet. Aus der Größe des dann vom anderen Ende der Leitbahn aufgenommenen Sekundärelektronen-Signals kann dann gelesen werden, ob eine leitende Verbindung zwischen den beiden Enden der Leitbahn besteht. Dieses Verfahren weist den Nachteil auf, daß es sich in der Praxis als schwierig erweist, zwei Elektronensonden mit unterschiedlicher Energie gleichzeitig und räumlich dicht benachbart zu erzeugen.

Aus Vac. Sci. Technol., Vol. 19, No. 4, Nov./Dez. 1981, Seite 1016, ist eine von H. C. Pfeiffer et al. mit insgesamt 3f et al vorgeschlagene Vorrichtung bekannt, die ein praktisch durchführbares Verfahren zur Prüfung von Mikroverdrahtungen mit Elektronensonden ermöglicht. Bei diesem bekannten Verfahren wird mit einer ersten Elektronensonde die Probe aufgeladen, und mit einer zweiten Elektronensonde wird das Potential an einem Ende der Leitbahn verändert, um dann mit einer Elektronensonde die Potentialänderung am anderen Ende der Leitbahn zu bestimmen. Bei diesem bekannten Verfahren wirkt sich nachteilig aus, daß der Widerstand der Leitbahn aus einer zeitlichen Potentialänderung bestimmt werden muß und daß bei diesem bekannten Verfahren bis zu drei Elektronenstrahlerzeuger notwendig sind.

Die beim Stand der Technik genannten Verfahren haben den Nachteil, daß sie nicht belastungsfrei arbeiten und daß gleichzeitig der Widerstand einer Leitbahn aus der zeitlichen Änderung des Ladungszustands der Leitbahn geschlossen werden muß.

Ein Elektronenstrahl-Meßverfahren zur kontaktlosen Überprüfung von Leiterplatten und Verdrahtungsmodulen auf Kurzschlüsse und Unterbrechungen ist aus der europäischen Offenlegungsschrift EP-A-66 070 bekannt. Bei diesem Verfahren erfolgt die Aufladung der Leiterbahnen durch die großflächige Bestrahlung der zu untersuchenden Probe mit einem stark divergenten Elektronenstrahl (flood beam), der in Abhängigkeit von dem jeweils durchzuführenden Test mit Hilfe einer oberhalb bzw. unterhalb der Probe angeordneten Elektronenkanone erzeugt werden kann. Der so an den einzelnen Kontaktpunkten der Leiterbahn aufgebaute, die leitende bzw. nichtleitende Verbindung zu anderen Kontaktpunken kennzeichnende Ladungszustand, wird anschließend mit einem zweiten, feingebündelten Elektronenstrahl unter Änderung des Ladungszustandes abgetastet. Auch dieses bekannte Verfahren arbeitet nicht belastungsfrei und erfordert einen hohen apparativen Aufwand, da bis zu 3 Strahlerzeuger notwendig sind.

Der vorliegenden Erfindung liegt die Aufgabe zugrunde, ein Verfahren der eingangs genannten Art anzugeben, das eine Widerstandsbestimmung belastungsfrei und ohne zeitliche Änderungen des Ladungszustands eines Objekts erlaubt.

Diese Aufgabe wird erfindungsgemäß durch ein Verfahren nach dem Anspruch 1 gelöst. Ausgestaltungen und Vorteile der Erfindung sind in den Unteransprüchen, der Beschreibung und der Zeichnung dargestellt.

Für eine praktische Realisierung eines erfindungsgemäßen Verfahrens wird nur ein einziger Elektronenstrahlerzeuger benötigt, welcher Elektronenstrahlen mit der Energie $2E_0$ und $E_0$ erzeugen kann. Bei einem erfindungsgemäßen Verfahren erfolgt die Widerstandsmessung eines Objekts belastungsfrei. Bei einem erfindungsgemäßen Verfahren ist es daher nicht notwendig, schnelle Potentialänderungen meßtechnisch zu erfassen. Durch entsprechende Ausgestaltung des Detektors für die Sekundärelektronen ist bei einer Vorrichtung zur Durchführung eines erfindungsgemäßen Verfahrens ein gutes Signal-/Rauschverhältnis erzielbar.

Ausführungsbeispiele der Erfindung sind in der Zeichnung dargestellt und werden im folgenden näher beschrieben.

Figur 1 zeigt eine Kurve zur grafischen Ermittlung der stationären Aufladung einer Probe auf das Potential — $U_2$ bei Bestrahlung mit einer Elektronensonde.

Figur 2 zeigt das Prinzip eines erfindungsgemäßen Verfahrens zur Prüfung einer leitenden Verbindung von oben nach unten bei einer Leiterplatte.

Figur 3 zeigt das Prinzip eines erfindungsgemäßen Verfahrens zur Überprüfung einer Verbindung in der oberen Ebene einer Leiterplatte.

Figur 4 zeigt eine entsprechende Detektorgeometrie zur Gewährleistung eines guten Signal-/

Rauschverhältnisses bei einer Vorrichtung zur Durchführung eines erfindungsgemäßen Verfahrens.

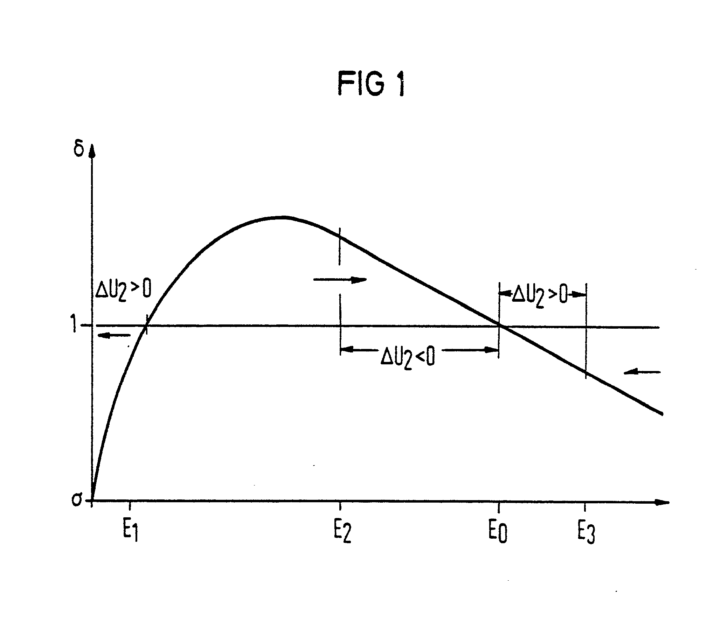

Fig. 1 zeigt eine Kurve zur grafischen Ermittlung der stationären Aufladung einer Probe auf das Potential $-U_2$ bei Bestrahlung der Probe mit einer Elektronensonde. Die Primärelektronen haben, wenn sie das Elektronenstrahl-Erzeugungssystem verlassen haben, eine Primärenergie von $E_{PE} = eU_1$. Im stationären Zustand treffen diese Primärelektronen auf eine Probe, welche eine Energie von $E_{PR} = eU_2$ aufweist. Im stationaären Fall werden die Primärelektronen durch die Gegenspannung $U_2$ abgebremst, bevor sie auf die Probe auftreffen. Die Primärelektronen treffen daher auf die Probe mit einer Energie $E = E_{PE} - E_{PR} - e(U_1 - U_2)$ auf. Fig. 1 zeigt die totale Elektronenausbeute $\sigma$ in Abhängigkeit von dieser Auftreffenergie der Primärelektronen auf die Probe.

An der Oberfläche der Probe kann sich eine positive Aufladung ausbilden, falls mehr Elektronen die Oberfläche der Probe verlassen als in der Probe steckenbleiben ($\sigma > 1$). Wenn ein großer Teil der Primärelektronen unterhalb der Oberfläche der Probe steckenbleibt, kann eine negative Raumladung erzeugt werden, die auch bis zur Oberfläche der Probe durchdringen kann ($\sigma < 1$). Ist eine Probe durch Bestrahlen mit einer Elektronensonde aufgeladen worden, so ist im stationären Fall die Zahl der die Probe verlassenden Elektronen gleich der Zahl der auf die Probe einfallenden Elektronen : $\sigma = 1$. Die die Probe verlassenden Elektronen können dabei als Sekundärelektronen oder als Rückstreuelektronen oder in einem Probenstrom die Probe verlassen.

Beträgt beispielsweise die Auftreffenergie E der Primärelektronen auf die Probe $E = E_1$ und ist das Probenpotential der Probe zunächst $-U_2 = 0$, so ist vor Erreichen des stationären Zustands die Elektronenausbeute $\sigma < 1$, und die Probe lädt sich solange negativ auf, bis auf der Probe eine Gegenspannung $U_2 = E_1/e$ aufgebaut worden ist. Dann ist der stationäre Zustand erreicht und die Primärelektronen werden von der negativen Probe vollständig abgebremst ; die Auftreffenergie E der Primärelektronen ist bei diesem stationären Zustand Null und damit ist auch die Elektronenausbeute $\sigma = 0$.

Beträgt die Auftreffenergie E der Primärelektronen $E = E_2$, so ist die Elektronenausbeute bei Beginn der Aufladung der Probe $\sigma > 1$ und die Probe lädt sich positiv auf, bis im stationären Fall eine Gegenspannung $U_2 = (E_2 - E_0)/e$ erreicht ist, wobei $E_0$ die obere Auftreffenergie der Primärelektronen auf die Probe bedeutet, bei der für die Elektronenausbeute $\sigma = 1$ gilt. Eine entsprechend negative Aufladung der Probe im stationären Fall ergibt sich bei einer Auftreffenergie der Primärelektronen auf die Probe von $E = E_3$. Die Gegenspannung beträgt dann in diesem Fall $U_2 = (E_3 = E_0)/e$.

Die Kurve für die Elektronenausbeute $\sigma$ hängt vom Material der Probe ab. Für isolierte Proben liegt im allgemeinen die Auftreffenergie $E_0$ der

Primärelektronen, bei der für die Elektronenausbeute $\sigma = 1$ gilt, etwa zwischen 1 keV und 4 keV. Bei gegebener Energie $E_{PE}$ der Primärelektronen verändert sich das Potential $-U_2$ auf der Probe solange, bis sich entweder der stationäre Zustand mit der Elektronenausbeute $\sigma = 1$ bei der Auftreffenergie $E_0$ eingestellt hat oder bis sich der stationäre Zustand $\sigma = 0$ bei einer Auftreffenergie $E = 0$ eingestellt hat.

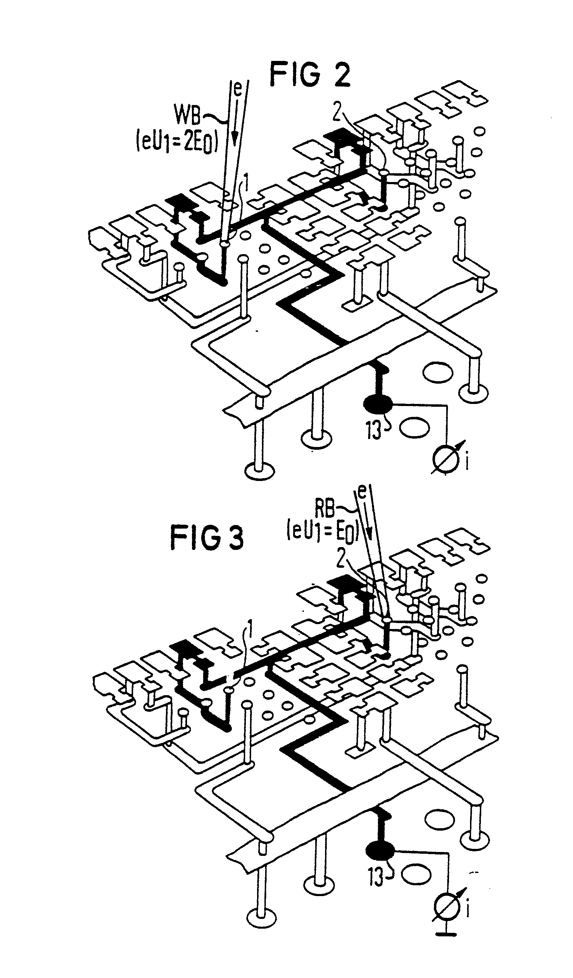

Fig. 2 zeigt das Prinzip eines erfindungsgemäßen Verfahrens zum Prüfen einer leitenden Verbindung bei Mikroverdrahtungen auf einer Leiterplatte von oben nach unten. Der Meßfleck 1 wird mit einem Schreibstrahl WB mit der Primärenergie $E_{PE} = eU_1 = 2E_0$ bestrahlt. Soll eine leitende Verbindung von oben nach unten, nämlich vom Meßfleck 1 zum Kontakt 13, geprüft werden, so kann diese Prüfung über den fließenden Probenstrom am Kontakt 13 erfolgen.

Im stationären Bestrahlungszustand weisen die Primärelektronen eine Auftreffenergie E auf die Probe von $E = E_0$ auf. In diesem stationären Zustand mit der Elektronenausbeute $\sigma = 1$ beträgt dann die Gegenspannung $U_2 = (2E_0 - E_0)/e = E_0/e$. Der Meßfleck 1 hat sich dabei negativ auf die Spannung $-U_2$ aufgeladen.

Fig. 3 zeigt das Prinzip eines erfindungsgemäßen Verfahrens zur Überprüfung einer leitenden Verbindung in der oberen Ebene beispielsweise einer Leiterplatte. Nach erfolgter Aufladung des Meßflecks 1 auf das Potential $-U_2 = -E_0/e$ kann nun der Schreibstrahl WB dadurch zu einem Lesestrahl RB umgeschaltet werden, daß die Energie der Primärelektronen $E_{PE} = eU_1 = 2E_0$ auf den Wert $E_{PE} = E_0$ umgeschaltet wird und zugleich auf den Meßfleck 2 zum Abtasten des Potentials dieses Meßflecks 2 gerichtet wird. Bei einer ungestörten leitenden Verbindung zwischen den Meßflecken 1 und 2 ist nun auch der Meßfleck 2 auf das Potential $-U_2 = -E_0/e$ aufgeladen. In diesem Fall ist die Auftreffenergie E der Primärelektronen auf den Meßfleck 2 gleich Null und somit ist auch die Elektronenausbeute $\sigma = 0$. Dies bedeutet, daß keine Sekundärelektronen ausgelöst werden. Dies bedeutet weiterhin, daß das Bild des Meßflecks 2 auf einem an den Sekundärelektronen-Detektor angeschlossenen Bildschirm dunkel erscheint. Für den Fall, daß die leitende Verbindung zwischen dem Meßfleck 1 und dem Meßfleck 2 gestört ist, hat sich der Meßfleck 2 nicht aufgeladen. Somit beträgt das Potential des Meßflecks 2 $-U_2 = 0$, so daß die Auftreffenergie E der Primärelektronen auf die Probe $E = E_0$ beträgt. Dies führt zu einer Elektronenausbeute $\sigma = 1$. In diesem Fall erscheint das Bild des Meßflecks 2 auf einem an den Sekundärelektronen-Detektor angeschlossenen Bildschirm hell.

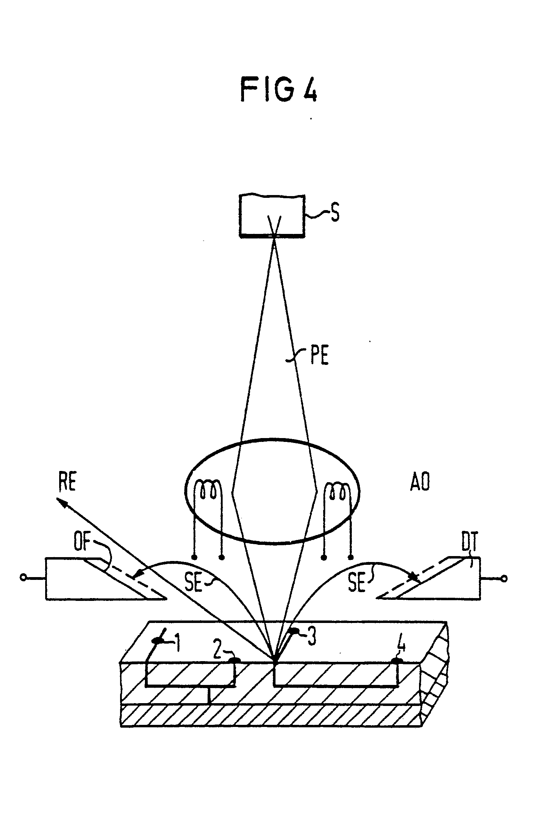

Fig. 4 zeigt das Prinzip für ein Sekundärelektronen-Spektrometer, bei dem durch eine entsprechende Detektorgeometrie ein gutes Signal-/Rauschverhältnis erreichbar ist. Die von einem Elektronenstrahl-Erzeugungssystem S ausgehenden Primärelektronen PE durchlaufen ein Ablenkobjektiv AO und treffen sodann auf die Oberfläche beispielsweise einer Leiterplatte mit den Meßflecken 1, 2, 3, 4 auf. Die für den Nachweis von langsamen Sekundärelektronen SE empfindliche Oberfläche des Detektors DT ist der Probengeometrie geeignet anzupassen.

**Patentansprüche**

1. Verfahren zum berührungslosen Testen der elektrischen Eigenschaften eines Objektes, insbesondere einer Mikroverdrahtung, bei dem das Objekt von einem Korpuskularstrahl aufgeladen wird und die dadurch auf dem Objekt erzeugte Potentialverteilung mit einem weiteren Korpuskularstrahl durch Nachweis der auf dem Objekt ausgelösten Sekundärelektronen abgetastet wird, dadurch gekennzeichnet,

— daß ein erster Punkt (1) des Objektes mit einem Korpuskularstrahl (WB) aufgeladen wird,

— daß nach Erreichen eines stationären Zustandes die Energie des Korpuskularstrahles derart verändert wird, daß sie im Bereich des Neutralpunktes ($E_0$) liegt,

— daß der Korpuskularstrahl (RB) anschließend auf mindestens einen weiteren Punkt (2, 3, 4, 13) des Objektes gerichtet wird,

— und daß das Potential dieses Punktes durch Nachweis der ausgelösten Sekundärelektronen (SE) in einem Detektor (DT) ohne Änderung des Ladungszustandes abgefragt wird.

2. Verfahren nach Anspruch 1, dadurch gekennzeichnet, daß beim Aufladen des Objektes mit einem Korpuskularstrahl (WB) gearbeitet wird, dessen Energie dem 2-fachen der Neutralpunktenergie ($E_0$) entspricht.

**Claims**

1. A method for the contactless testing of the electrical properties of an object, in particular a micro-wiring, where the object is charged by a corpuscular beam and the potential distribution which is thus produced on the object is scanned by a further corpuscular beam by the detection of the secondary electrons which are triggered on the object, characterised in that

— a first point (1) of the object is charged by a corpuscular beam (WB),

— when a stationary state has been reached the energy of the corpuscular beam is modified in such manner that it lies in the region of the neutral point ($E_0$),

— the corpuscular beam (RB) is then directed towards at least one further point (2, 3, 4, 13) of the object,

— and that the potential of this point is interrogated by detecting the triggered secondary electrons (SE) in a detector (DT) without modifying the charge state.

2. A method as claimed in claim 1, characterised in that the object is charged by a corpuscular beam (WB) whose energy corresponds to twice the neutral point energy ($E_0$).

**Revendications**

1. Procédé pour tester, sans contact, les propriétés électriques d'un objet, notamment d'un microcâblage, selon lequel on charge l'objet à l'aide d'un faisceau corpusculaire et on explore la distribution de potentiel obtenue de ce fait sur l'objet, en utilisant un autre faisceau corpusculaire et en détectant les électrons secondaires dont l'émission est déclenchée sur l'objet, caractérisé par le fait

— qu'on charge un premier point (1) de l'objet avec un faisceau corpusculaire (WB),

— qu'une fois un état stationnaire atteint, on modifie l'énergie du faisceau corpusculaire de manière qu'elle se situe dans la zone du point neutre ($E_0$),

— qu'on dirige ensuite le faisceau corpusculaire (RB) sur au moins un autre point (2, 3, 4, 13) de l'objet,

— qu'on interroge le potentiel de ce point en détectant les électrons secondaires (SE) émis dans un détecteur (DT) sans modification de l'état de charge.

2. Procédé suivant la revendication 1, caractérisé par le fait que lors de la charge de l'objet avec un faisceau corpusculaire (WB), on opère avec un faisceau dont l'énergie correspond au double de l'énergie ($E_0$) du point neutre.

# FIG 1

# FIG 2

WB
$(eU_1 = 2E_0)$

# FIG 3

RB
$(eU_1 = E_0)$

# FIG 4